# EUROPÄISCHE PATENTSCHRIFT

(11) **EP 1 198 828 B1**
(45) Veröffentlichungstag und Bekanntmachung des Hinweises auf die Patenterteilung: **19.09.2007**
(21) Anmeldenummer: 00945635.1
(22) Anmeldetag: 09.06.2000
(51) Int. Cl.: H01L 21/3213

(54) **VERFAHREN ZUR HERSTELLUNG EINES HALBLEITERSPEICHERBAUELEMENTS**
METHOD FOR PRODUCING A SEMICONDUCTOR MEMORY COMPONENT
PROCEDE DE PRODUCTION D'UN COMPOSANT DE STOCKAGE A SEMI-CONDUCTEUR

(30) Priorität: 10.06.1999 DE 19926501
(43) Veröffentlichungstag der Anmeldung: 24.04.2002
(73) Patentinhaber: Infineon Technologies AG, 81669 München (DE)
(72) Erfinder: ENGELHARDT, Manfred, D-83620 Feldkirchen-Westerham (DE); WEINRICH, Volker, F-75013 Paris (FR); KREUPL, Franz, D-80469 München (DE); SCHIELE, Manuela, GB-New Castle upon Tyne, NE6 4 HAT (GB)
(74) Vertreter: Epping - Hermann - Fischer
(86) Internationale Anmeldenummer: PCT/DE2000/001896
(87) Internationale Veröffentlichungsnummer: WO 2000/077841

(56) Entgegenhaltungen:
- US-A- 5 335 138
- US-A- 5 786 259
- US-A- 5 907 782

## Beschreibung

Die vorliegende Erfindung betrifft ein Verfahren zur Herstellung eines Halbleiterspeicherbauelements gemäß dem Oberbegriff des Anspruchs 1, wie aus der US-A-5 464 786, der US-A-5 506 166 und der US-A-5 581 436 bekannt.

Weiterhin ist aus der WO 99/27581 bekannt, auf einem Substrat eine Isolationsschicht mit einem darin befindlichen Kontaktstopfen vorzusehen. Darauf wird ein Dielektrikum mit einer Ausnehmung gebildet und auf dieser Struktur eine Barrierenschicht als Diffusionsbarriere vorgesehen. Dann werden eine untere Elektrodenschicht, eine Dielektrikumsschicht und eine obere Elektrodenschicht für einen Speicherkondensator abgeschieden. Daran anschließend wird eine Pufferschicht abgeschieden, welche die Struktur bedeckt und die verbleibende Ausnehmung ausfüllt. In einem chemisch-mechanischen Planarisierungsschritt wird schließlich die Pufferschicht bis zur Barrierenschicht abgetragen und dann die an der Oberfläche freiliegende Barrierenschicht entfernt.

Die betreffenden Halbleiterspeicherbauelemente umfassen zumindest einen Speicherkondensator mit einem Speichermedium, das aus einer ferroelektrischen Dünnschicht bzw. einer Dünnschicht mit hoher Elektrizitätskonstante besteht. Beim Einsatz derartiger Speichermedien sind Ausheilprozesse bei hohen Temperaturen, charakteristischer Weise in der Größenordnung von 800°C, in oxidierender Umgebung mit insbesondere Sauerstoff als Prozeßgas notwendig. Materialdiffusionsprozesse, beispielsweise durch Aufoxidieren von Polysilizium-Stopfen (sogenannten -Plugs), welche der Kontaktierung zum Silizium-Substrat dienen, müssen vermieden werden, weil sie zu einer Beeinträchtigung oder gar zum Ausfall des Halbleiterspeicherbauelements führen können.

Um Materialdiffusionsprozesse auszuschließen, werden Diffusionsbarrieren bzw. Sandwiches derartiger Barrieren in Kombination mit Haftschichten eingesetzt, beispielsweise bestehend aus Ir, IrO₂, IrO. Im folgenden werden diese Strukturen insgesamt als Barrieren bzw. Barrierenschicht bezeichnet. Diese Barrieren werden zwischen dem Speicherkondensator und dem Silizium-Substrat angeordnet. Das heißt, auf die Barrierenschicht wird die untere Elektrode, die sogenannte Bottom-Elektrode des Speicherkondensators, die typischerweise aus Pt, Ru, RuO₂ besteht, aufgebracht. Um eine optimale Haftung der unteren Elektrode auf der Barriere zu gewährleisten, muß die Barrierenschicht eine möglichst große ebene Kontaktfläche aufweisen. Außerdem ist ein möglichst niedriger Kontaktwiderstand erforderlich, zumal Elektrodendünnschichten üblicherweise schlecht auf dem Silizium-Substrat haften.

Die Barrierenschichten lassen sich nur schlecht im Plasma strukturieren, da sie unzureichende bzw. nichtflüchtige Verbindungen in den zur Strukturübertragung eingesetzten Prozeßchemien bilden. Die Strukturierung erfolgt daher bislang bevorzugt durch physikalischen Sputterabtrag der Schichten. Bei der Strukturübertragung werden deshalb zu Maskenmaterialien geringe Selektivitäten erzielt. Im Fall einer Barrierenschicht aus IrO₂ trägt außerdem der dabei freiwerdende Sauerstoff zusätzlich zur Lackabtragung bei. Außerdem führt die Strukturübertragung zu einer signifikanten CD(= Critical Dimension)-Änderung und/oder zu Profilabschrägungen durch ein laterales Zurückziehen des Resists bzw. durch Anlagerung von nur schwierig bzw. gar nicht entfernbaren Redepositionen an den Seitenwänden der erzeugten Struktur oder durch Kombination aus beidem.

Bekannt ist außerdem im Zusammenhang mit dem Aufbringen von Speicherkondensatoren auf einem Siliziumsubstrat die Verwendung einer dielektrischen harten Maske bzw. Hardmask, die beispielsweise aus SiO₂, SiN oder SiON besteht. Wegen der grundsätzlich geringeren Erodierbarket dieser Maskenschichten sind bei einer Prozeßführung mit Hilfe dieser Maskenschichten höhere Selektivitäten realisierbar. Aufgrund der Maskenfacettierung bei bevorzugt physikalischem Sputterabtrag im Plasmastrukturierungsprozeß muß jedoch die Dicke der Maskenschicht größer gewählt werden als allein durch die Selektivität vorgegeben, um eine Übertragung der Facette in die zu strukturierende Schicht zu vermeiden. Die Entfernung der nach erfolgter Strukturübertragung verbleibenden Maske in einem Plasmaätzprozeß führt zu einer zusätzlichen Vergrößerung der erwünschten Topographie von mindestens der Dicke der zu entfernenden Maskenschicht.

Derartige Strukturierungsprozesse sind beispielsweise bekannt aus der US-A-5 464 786, der US-A-5 506 166 und der US-A-5 581 436. Naßprozesse zum nachfolgenden Abtragen der Maskenschicht scheiden wegen der damit verbundenen zusätzlichen isotropen Unterätzung der Strukturen prinzipiell aus.

In der US-A-5,786,259 ist die Herstellung eines Kondensators mit oberer Elektrode, Dielektrikumsschicht und unterer Elektrode, die durch eine Barrierenschicht von einem Substrat getrennt ist, beschrieben. Die untere Elektrode und die Barrierenschicht werden durch eine von einer Ätzstoppschicht gebildete Maske strukturiert. Die durch die Ätzstoppschicht gebildete Hartmaske wird durch einen naßchemischen Prozeßschritt entfernt.

In der US 5,907,782 ist die Herstellung einer DRAM-Speicherzelle mit Stapelkondensator beschrieben. Zur Strukturierung des obersten Teils des Speicherkondensators wird ein Dielektrikum abgeschieden und mit einer HSG-Silizium-Hartmaske strukturiert. Darüber wird eine leitfähige Schicht abgeschieden und gemeinsam mit der Hartmaske durch einen CMP-Prozeßschritt planarisiert.

Eine Aufgabe der vorliegenden Erfindung besteht darin, ein Verfahren der eingangs genannten Art zu schaffen, welches eine optimal große Oberfläche bzw. Haftfläche der Barrierenschicht gegenüber der unteren Elektrode des Speicherkondensators gewährleistet.

Gelöst wird diese Aufgabe durch das Verfahren nach Anspruch 1.

Vorteilhafte Weiterbildungen der Erfindung sind in den Unteransprüchen angegeben.

Mit anderen Worten sieht die Erfindung eine vollständige Einbettung der strukturierten Barriereschicht mitsamt der auf ihr verbleibenden Maskenschicht in SiO₂ mittels CVD (chemische Dampfabscheidung) vor, gefolgt von einem CMP(Chemical Mechanical Polishing)-Prozeß, vorteilhafterweise mit Polierstopp auf der Kontaktoberfläche der Barrierenschicht. Diese Prozeßschritte gewährleisten Barrierenschichten mit minimaler Oberflächen- bzw. Kontaktflächenänderung, die auch, als CD (Critical Dimension) bezeichnet wird, unter zwar unter Erzeugung senkrechter Seitenwände aufgrund der Verwendung einer Hardmaske für die Strukturübertragung. Mittels der dadurch erzielten großflächigen und ebenen Kontaktfläche für die darauf aufzubringende untere Elektrode ohne Erzeugung zusätzlicher Topographie aufgrund der erfindungsgemäßen Kombination von CVD-SiO₂ und SiO₂-CMP wird eine optimale Haftung des Speicherkondensators bei niedrigem Kontaktwiderstand gewährleistet.

Ein weiterer Vorteil des erfindungsgemäßen Verfahrens besteht darin, daß die Barrierenschicht mit ihrer freigelegten Kontaktfläche in einer umgebenden SiO₂-Schicht mit Ausnahme ihrer Oberfläche bzw. ihrer Kontaktfläche eingebettet ist. Eine derartige Struktur mit vergrabener Barrierenschicht ergibt sich aufgrund der erfindungsgemäßen Verfahrensführung mit CVD-SiO₂ und SiO₂-CMP.

Nachfolgend wird die Erfindung anhand der Zeichnung beispielhaft näher erläutert.

Es zeigen:
- Fig. 1: eine schematische Querschnittsansicht eines Halbleiterspeicherbauelements im Bereich eines Speicherkondensators;
- Fig. 2: schematisch den bisherigen Herstellungsprozeß für die Barrierenschicht der Anordnung von Fig. 1, wobei im oberen Teil von Fig. 2 das Verfahren nach Lackauftrag und im unteren Teil von Fig. 2 das Verfahren nach erfolgter Strukturübertragung;
- Fig. 3A und 3B: die Verfahrensführung unter Nutzung einer Hard Mask (harten Maske); und
- Fig. 3C und 3D: die erfindungsgemäße Verfahrensführung mit CVD-SiO₂ (Fig. 3C) und SiO₂-CMP (Fig. 3D).

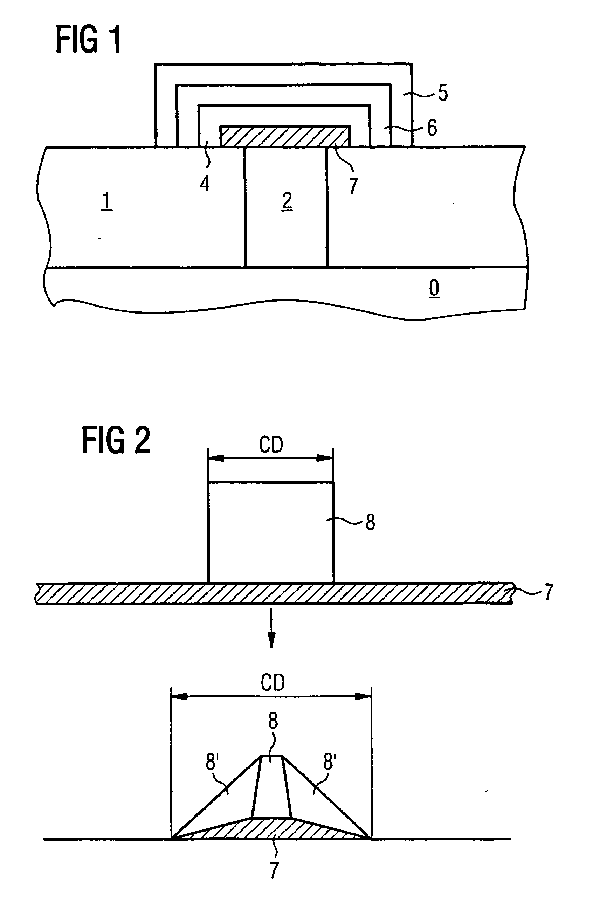

Wie in Fig. 1 schematisch gezeigt, ist auf ein mit z.B. SiO₂ beschichtetes Substrat 0 im Bereich eines dort in herkömmlicher Weise ausgebildeten Stopfens bzw. Plug 2 aus Poly-Si, W und dergleichen, welcher Stopfen 2 sich bis zur Oberseite der SiO₂-Schicht 1 erstreckt, ein Speicherkondensator 3 angeordnet, der eine untere Elektrode 4, eine sogenannte Bottom-Elektrode, eine obere Elektrode 5, eine sogenannte Top-Elektrode und ein dazwischen angeordnetes Dielektrikum 6 bzw. ein Speichermedium aus einer ferroelektrischen Dünnschicht bzw. einer Dünnschicht mit hoher Dielektrizitätskonstante umfaßt. Um das eingangs abgehandelte Problem einer Materialdiffusion zu verhindern, ist zwischen der unteren Elektrode 4 und der Oberseite des mit SiO₂ beschichteten Substrats eine Barrierenschicht 7 angeordnet.

Ein herkömmlicher Prozeßablauf zur Erzeugung der Barrierenschicht 7 ist in Fig. 2 schematisch ohne Darstellung des Substrats gezeigt. Demnach wird in bekannter Weise auf der Oberseite der Barrierenschicht 7 eine Lackmaske 8 aufgebracht, die aufgrund der Maskenstruktur Abdeckungsbereiche einer bestimmten Flächenausdehnung (mit CD = Cirtical Dimension) aufweist. Diese Anordnung ist im oberen Teil von Fig. 2 gezeigt. Im unteren Teil von Fig. 2 ist die Anordnung nach Strukturierung der Barrierenschicht 7 mit verbleibender Lackmaske 8 gezeigt, wobei deutlich hervorgeht, daß die Oberfläche bzw. CD der Lackmaske 8 stark verändert ist, wobei häufig durch Redepositionen 8' schräg abfallende Flanken der Lackmaske verbleiben. In ähnlicher Weise zeigt die unter der Lackmaske verbleibende Barrierenschicht 7 eine verringerte ebene Oberfläche mit schräg abfallenden Flanken.

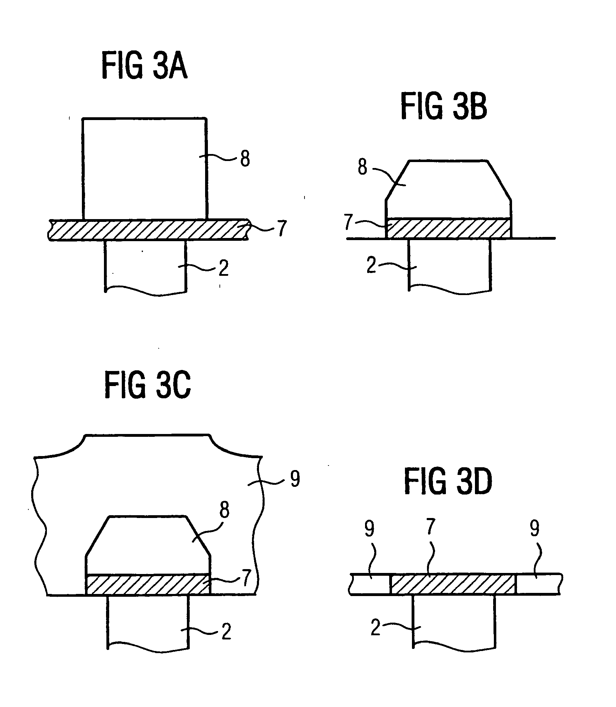

Die ungünstige Profilabschrägung der Barrierenschicht 7 gemäß diesem herkömmlichen Verfahren wird durch Verwendung einer ebenfalls mit 8 bezeichneten harten Maske, einer sogenannten Hard-Mask vermieden, wie schematisch in Fig. 3A und 3B gezeigt, wobei Fig. 3A den Zustand der Anordnung vor der Ätzung und Fig. 3B den Zustand der Anordnung nach der Ätzung zeigt. Werden nachfolgend auf den durch Fig. 3B verdeutlichten Prozeßzustand Naßprozesse angewendet, um die harte Maske 8 zu entfernen, ist mit einer zusätzlichen isotropen Unterätzung der Strukturen zu rechnen.

Dieser Nachteil wird erfindungsgemäß durch die Prozeßführung gemäß Fig. 3C und Fig. 3D vermieden. Gemäß Fig. 3C wird demnach die strukturierte Barrierenschicht 7 mitsamt der auf ihr verbliebenen Maskenschicht 8 mittels einem CVD-Prozeß in SiO₂ eingebettet. Die SiO₂-Einbettungsschicht ist mit der Bezugsziffer 9 bezeichnet. Daraufhin erfolgt, wie in Fig. 3D gezeigt, ein CMP-Prozeß mit Polierstopp auf der Oberfläche der Barrierenschicht 7, durch welchen von der Barrierenschicht 7 die Hartmaske 9 vollständig unter Belassung einer großflächigen ebenen Oberfläche bzw. Kontaktfläche abgetragen wird, auf welcher die nachfolgend aufzubringende untere Elektrodenschicht 4 des Speicherkondensators 3 ohne Erzeugung zusätzlicher Topographie und mit guter Haftung aufgebracht werden kann.

## Patentansprüche

1. Verfahren zur Herstellung eines Halbleiterspeicherbauelements mit einem Silizium-Substrat (0), auf welchem zumindest ein Speicherkondensator mit unterer Elektrode (4), oberer Elektrode (5) und einer dazwischen liegenden Dielektrikumschicht (6) angeordnet ist, wobei die untere Elektrode (4) von dem Silizium-Substrat (0) durch eine Barrierenschicht (7), isoliert ist, mit den Schritten:
Aufbringen der Barrierenschicht (7);
Strukturieren der Barrierenschicht (7) vor dem Aufbringen des Speicherkondensators mittels einer Hartmaske (8);
Entfernen der nach der Strukturierung verbleibenden Hartmaske (8) unter Freilegung der strukturierten Barrierenschicht (7);
**gekennzeichnet durch** die Schritte:
Einbetten der strukturierten Barrierenschicht (7) und der darüber nach der Strukturierung verbleibenden Hartmaske (8) in eine Einbettungsschicht (9); und
Entfernen der nach der Strukturierung über der Barrierenschicht (7) verbleibenden Hartmaske (8) und der darüberliegenden Einbettungsschicht (9) mittels eines chemisch-mechanischen Polierschrittes.

2. Verfahren nach Anspruch 1, **dadurch gekennzeichnet, daß** der chemisch-mechanische Polierschritt an der Oberfläche der Barrierenschicht (7) gestoppt wird.

3. Verfahren nach Anspruch 1 oder 2, **dadurch gekennzeichnet, daß** das Halbleiterspeicherbauelement für ein DRAM oder ein FeRAM verwendet wird.

4. Verfahren nach Anspruch 1, 2 oder 3, **dadurch gekennzeichnet, daß** für die Dielektrikumsschicht (6) ein ferroelektrisches Material verwendet wird.

5. Verfahren nach einem der vorherigen Ansprüche, **dadurch gekennzeichnet, daß** die Barrierenschicht (7) als eine Diffusionsbarriere oder ein Diffusionsbarrieren-Sandwich in Kombination mit Haftschichten ausgestaltet wird.

6. Verfahren nach einem der vorherigen Ansprüche, **dadurch gekennzeichnet, daß** die Haftschichten aus Ir, IrO₂ oder IrO hergestellt werden.

7. Verfahren nach einem der vorherigen Ansprüche, **dadurch gekennzeichnet, daß** die Hartmaske (8) aus SiO₂, SiN oder SiON hergestellt wird.

8. Verfahren nach einem der vorherigen Ansprüche, **dadurch gekennzeichnet, daß** die Einbettungsschicht (9) durch chemische Dampfphasenabscheidung aus SiO₂ hergestellt wird.

9. Verfahren nach einem der vorherigen Ansprüche, **dadurch gekennzeichnet, daß** auf dem Substrat (0) eine Isolationsschicht (1) mit einem darin befindlichen Kontaktstopfen (2) vorgesehen wird, worauf die Barrierenschicht (7) als Diffusionsbarriere vorgesehen wird.

## Claims

1. Method for fabricating a semiconductor memory component having a silicon substrate (0), on which at least one storage capacitor having a lower electrode (4), an upper electrode (5) and a dielectric layer (6) between the electrodes is arranged, the lower electrode (4) being insulated from the silicon substrate (0) by a barrier layer (7), comprising the steps:
application of the barrier layer (7);
patterning of the barrier layer (7) prior to the application of the storage capacitor by means of a hard mask (8);
removal of the hard mask (8) which remains after the patterning, so as to uncover the patterned barrier layer (7);
**characterized by** the steps:
embedding of the patterned barrier layer (7) and of the hard mask (8) which remains above it after the patterning in an embedding layer (9); and
removal of the hard mask (8) which remains above the barrier layer (7) after the patterning and of the embedding layer (9) above it by means of a chemical mechanical polishing step.

2. Method according to Claim 1, **characterized in that** the chemical mechanical polishing step is stopped at the surface of the barrier layer (7).

3. Method according to Claim 1 or 2, **characterized in that** the semiconductor memory component is used for a DRAM or an FeRAM.

4. Method according to Claim 1, 2 or 3, **characterized in that** a ferroelectric material is used for the dielectric layer (6).

5. Method according to one of the preceding claims, **characterized in that** the barrier layer (7) is designed as a diffusion barrier or a diffusion barrier sandwich in combination with adhesion layers.

6. Method according to one of the preceding claims, **characterized in that** the adhesion layers are made from Ir, IrO₂ or IrO.

7. Method according to one of the preceding claims, **characterized in that** the hard mask (8) is made from SiO₂, SiN or SiON.

8. Method according to one of the preceding claims, **characterized in that** the embedding layer (9) is produced from SiO₂ by chemical vapor deposition.

9. Method according to one of the preceding claims, **characterized in that** an insulation layer (1) in which there is a contact plug (2) is provided on the substrate (0), and the barrier layer (7) is provided thereon as a diffusion barrier.

## Revendications

1. Procédé de production d'un composant de mémoire à semi-conducteurs comprenant un substrat (0) de silicium, sur lequel est disposé au moins un condensateur de mémoire ayant une électrode (4) inférieure, une électrode (5) supérieure et une couche (6) diélectrique disposée entre elles, l'électrode (4) inférieure étant isolée du substrat (0) en silicium par une couche (7) barrière, comprenant les stades de :
dépôt de la couche (7) barrière ;
structuration de la couche (7) barrière avant le dépôt du condensateur de mémoire au moyen d'un masque (8) dur ;
élimination du masque (8) dur restant après la structuration en mettant à nu la couche (7) barrière structurée ;
**caractérisé par** les stades de :
incorporation de la couche (7) barrière structurée et du masque (8) dur restant au-dessus après la structuration dans une couche (9) d'incorporation ; et
élimination du masque (8) dur restant après la structuration au-dessus de la couche (7) barrière et de la couche (8) d'incorporation se trouvant au-dessus au moyen d'un stade de polissage chémio-mécanique.

2. Procédé de production suivant la revendication 1, **caractérisé en ce que** l'on arrête le stade de polissage chémio-mécanique à la surface de la couche (7) barrière.

3. Procédé de production suivant la revendication 1 ou 2, **caractérisé en ce que** l'on utilise le composant de mémoire à semi-conducteurs pour une DRAM ou une FeRAM.

4. Procédé de production suivant la revendication 1, 2 ou 3, **caractérisé en ce que** l'on utilise pour la couche (6) diélectrique un matériau ferro-électrique.

5. Procédé de production suivant l'une des revendications précédentes, **caractérisé en ce que** l'on conforme la couche (7) barrière sous la forme d'une barrière de diffusion ou d'un sandwich de barrière de diffusion en combinaison avec des couches d'accrochage.

6. Procédé de production suivant l'une des revendications précédentes, **caractérisé en ce que** les couches d'accrochages sont en Ir, IrO₂ ou IrO.

7. Procédé de production suivant l'une des revendications précédentes, **caractérisé en ce que** le masque (8) dur est en SiO₂, SiN ou SiON.

8. Procédé de production suivant l'une des revendications précédentes, **caractérisé en ce que** l'on produit la couche (9) d'incorporation par dépôt chimique en phase vapeur à partir de SiO₂.

9. Procédé de production suivant l'une des revendications précédentes, **caractérisé en ce que** l'on prévoit sur le substrat (0) une couche (1) isolante ayant un tampon (2) de contact se trouvant en son sein la couche (7) barrière étant prévue dessus sous la forme d'une barrière de diffusion.
